# EUROPEAN PATENT SPECIFICATION

(11) **EP 3 665 731 B1**
(45) Date of publication and mention of the grant of the patent: **13.12.2023**
(21) Application number: 18758690.4
(22) Date of filing: 09.08.2018
(51) Int. Cl.: H01L 31/0248, H01G 9/21

(54) **ENERGY STORAGE**
ENERGIESPEICHER
STOCKAGE D'ÉNERGIE

(30) Priority: 10.08.2017 GB 201712878
(43) Date of publication of application: 17.06.2020
(73) Proprietor: Power Roll Limited, Sunderland Tyne and Wear SR5 3NZ (GB)
(72) Inventor: TOPPING, Alexander John, Sunderland Tyne and Wear SR5 3NZ (GB)
(74) Representative: HGF
(86) International application number: PCT/GB2018/052268
(87) International publication number: WO 2019/030528

(56) References cited:
- EP-A2- 1 039 553
- EP-B1- 3 549 175
- WO-A1-2012/128748
- DE-A1-102012 210 875
- US-A1- 2014 230 895

## Description

The present invention relates to an energy storage device.

The demand for sources of renewable energy has driven significant improvements in the cost and efficiency of solar photovoltaic cells but existing technology still represents a relatively expensive method of generating electricity.

The demand for sources of renewable energy has also driven improvements in energy storage. The efficiency of energy storage must be increased and/or the cost of energy storage must be decreased, if renewable energy is going to meet more of the world's energy demand.

Document US 2014/230895 A1 discloses such an energy storage device.

The present invention aims to mitigate one or more of the disadvantages of existing energy storage devices.

In accordance with a first aspect of the present invention there is provided an energy storage device according to claim 1.

The material for storing electrical potential energy may store the electrical potential energy in the form of one or more of chemical energy, electrostatic energy, pseudocapacitance and electrostatic double layer capacitance (EDLC). The electrostatic energy may be referred to as an electric field.

The material for storing electrical potential energy may be and/or may be part of and/or may comprise a battery. When the material for storing electrical potential energy may be and/or may be part of and/or may comprise a battery, the material typically stores the electrical potential energy in the form of chemical energy.

The material for storing electrical potential energy may be and/or may be part of and/or may comprise a capacitor or supercapacitor. When the material for storing electrical potential energy may be and/or may be part of and/or may comprise a capacitor, the material typically stores the electrical potential energy in the form of one or more of electrostatic energy, pseudocapacitance and electrostatic double layer capacitance (EDLC).

The first face of the trough is also the first face of the peak. The second face of the trough is the second face of an adjacent and/or adjoining peak.

The first face of the trough is normally at a first angle relative to a normal from the substrate and the second face of the trough is normally at a second angle relative to the normal from the substrate. The first and second angles may be the same or substantially the same or may be different. The first and second angles are normally from 25 to less than or equal to 90°. The first and second angles are typically from 45 to less than 90°.

It may be an advantage of the present invention that the device provides a reliable way to store energy and in particular the device is less prone to short circuits compared to other known storage devices. Short circuits adversely affect the capacitance of the material for storing electrical potential energy.

The capacitor may be a high dielectric capacitor. It is normally a high dielectric capacitor in the troughs.

The energy storage device is typically an electrical energy storage device.

The material for storing electrical potential energy in the trough partially fills the troughs, completely fills the troughs or overfills the troughs.

The conductor on the first and/or second face of the trough may be a metal. The conductor on the first and/or second face of the trough may be a conductive non-metal. The conductor on the first and/or second face of the trough is typically in contact, normally electrical contact, with the material for storing electrical potential energy in the trough. The conductor on the first and/or second face of the trough is typically an electrical conductor.

The conductor on the first and/or second face of the trough may comprise one or more of carbon, coated carbon, carbon coated carrier, aluminium, bismuth, cadmium, chromium, tellurium, copper, gallium, gold, indium, lead, magnesium, manganese, samarium, scandium, silver, tin, zinc, terbium, selenium, molybdenum, yttrium, holmium, calcium, nickel, tungsten, platinum, palladium and vanadium.

There is typically a gap between the conductor on the first face and the conductor on the second face of the trough. The gap typically means that the conductor on the first face of the trough is not in electrical contact with the conductor on the second face of the trough. The gap is typically at the bottom of the trough.

It may be an advantage of the present invention that the trough defines a space between the conductor on the first face and conductor on the second face of the trough. The distance between the conductor on the first face and conductor on the second face of the trough is typically accurately defined, normally relatively accurately defined and/or consistent.

It may be an advantage of the present invention that the material for storing electrical potential energy in the trough is less likely to suffer from the effects of voltage breakdown compared to other known capacitor and supercapacitor structures. The energy storage device according to the present invention has reduced individual voltage across each trough.

The number of peaks and troughs relates to the operating voltage of the device. Unlike other known capacitor/supercapacitor devices that require multiple laminated layers, the energy storage device according to the present invention does not require multiple laminated layers but rather uses a series of peaks and troughs in one layer. The device shares the voltage over a number of troughs so that the voltage in each individual trough is below the breakdown level for the material for storing electrical potential energy.

The conductor on the first and/or second face of the trough and the material for storing electrical potential energy in the trough are normally all in electrical communication. The electrical communication is such that normally an electrical current can flow between the conductor on the first and/or second faces of the trough and the material for storing electrical potential energy.

The flow of electrical current between the conductor on the first and second faces of the trough and the material for storing electrical potential energy is typically complex and/or multidirectional. The flow of electrical current is between neighbouring troughs, through neighbouring peaks.

In a first arrangement, the electrical current may flow between one or more of a first to a second peak; the first to a third peak; the first to a fourth peak; the first to a fifth peak; the first to a sixth peak; the first to a seventh peak; and first to an eighth peak. Each peak may be surrounded by any number of neighbouring peaks.

In a second arrangement, the electrical current may flow between one or more of a first to a second peak; the first to a third peak; and the first to a fourth peak. Each peak may therefore be surrounded by four nearest neighbouring peaks. There are typically another four further neighbouring peaks. The second arrangement may be and/or may be referred to as a square arrangement.

The peaks may be in and/or may be referred to as a triangular or diamond arrangement.

The three-dimensional array of peaks and troughs may be a random distribution of peaks and troughs. That is to say the distribution of the peaks across the surface of the substrate is random and therefore the space between neighbouring peaks is varied and the size and/or shape of the troughs is varied. The three-dimensional array of peaks and troughs may be a pseudo random distribution of peaks and troughs.

The material for storing electrical potential energy in the troughs may be from 50 to 2000nm deep and/or thick, normally from 100 to 1000nm deep and/or thick and typically from 100 to 500nm deep and/or thick.

The conductor on the first face of the peaks may be from 20 to 1000nm deep and/or thick, normally from 30 to 500nm deep and/or thick and typically from 30 to 200nm deep and/or thick.

The conductor on the second face of the peaks may be from 10 to 1000nm deep and/or thick, normally from 10 to 500nm deep and/or thick and typically from 10 to 200nm deep and/or thick.

The energy storage device may also be an optoelectronic device. The first face of each trough may be coated with, that is may have a coat of, a semiconductor and the second face of each trough may be coated with, that is may have a coat of, the conductor. The first and second faces of each of the troughs may be coated with the semiconductor.

The material for storing electrical potential energy is typically a high dielectric material. It may be an advantage of the present invention that the high dielectric material aids operation of the optoelectronic device by smoothing out energy demand spikes, such as a surge when devices are turned on. The high dielectric material may be a high dielectric capacitor.

The semiconductor and the conductor may be in contact with another semiconductor in the trough. The material for storing electrical potential energy typically one or more of coats, is on top of, and covers the another semiconductor in the trough. The material for storing electrical potential energy normally fills any remaining volume of the trough not occupied by the semiconductor, conductor on the first and/or second face of the trough and/or the another semiconductor. The material for storing electrical potential energy may be a dielectric and/or insulator between two neighbouring troughs.

It may be advantageous for the material for storing electrical potential energy to overfill the trough, such that the material completely fills any remaining volume of the trough and also extends outside the and/or the volume of the trough. The material for storing electrical potential energy may overfill a plurality of troughs in this way to the extent that the material for storing electrical potential energy bridges across a plurality of troughs, forming a layer over them. The material for storing electrical potential energy may be a dielectric between two or more adjacent troughs. Overfilling the trough(s) may result in greater adhesion of the material for storing electrical potential energy to the device, and/or may increase the resulting capacitance of the device.

The second face of the trough may be coated with the semiconductor and the first face of the trough coated with a third semiconductor. The third semiconductor is typically an ion (e.g. proton) conductor. The third semiconductor may comprise one or more of molybdenum oxide, tungsten oxide, vanadium oxide, nickel oxide, copper oxide and other materials with similar properties.

The capacitor or supercapacitor typically provides the function of a supercapacitor, also referred to as an ultracapacitor. The function of the supercapacitor may be provided by the supercapacitor alone or may require the interaction of the supercapacitor with one or more of the semiconductor, conductor on the first and/or second face of the trough and another semiconductor.

In use, the optoelectronic device typically generates electrical energy. The optoelectronic device may be in electrical communication with a load. The load is typically an electrical component that consumes electric energy. The load may for example be a light source, such as a light bulb.

In use, the material for storing electrical potential energy typically stores electrical energy or charge that the load does not consume. In this way, excess electrical energy can be stored for future use by the load. There is therefore electrical energy available to the load when the optoelectronic device is not generating electrical energy.

The first and second faces of the trough are typically from 100nm to 30microns high, optionally from 7 to 15 microns high, normally from 1 to 3microns high.

The length of the first and second faces of the trough may be at least substantially the same or different.

At a second side of the trough there may be a gap between the semiconductor on the second face of the trough and the another semiconductor in the trough. It may be an advantage of the present invention that, in use, the gap between the semiconductor on the second face of the trough and the another semiconductor in the trough one or more of stops, mitigates and substantially reduces the occurrence of shunting across the trough and therefore typically between the first and second sides of the trough by displacing the another semiconductor.

The gap is typically an air gap. The gap may be filled with another material, preferably a non-conducting and/or electrically insulative material. The gap is typically a form of electrical insulation between the semiconductor on the second face of the trough and the another semiconductor in the trough. In an alternative embodiment the material for storing electrical potential energy in the trough is replaced with an air gap containing air. Air is a material for storing electrical potential energy, albeit typically a relatively weak capacitor or supercapacitor.

The gap may be filled with the material for storing electrical potential energy. The gap between the semiconductor and the another semiconductor at the second side of the trough, typically means that the another semiconductor is not in contact and/or is insulated from, the semiconductor.

The gap between the semiconductor on the second face of the trough and the another semiconductor in the trough may be at least 100nm in length, normally at least 300nm in length, typically at least 500nm in length and often from 400 to 600nm in length.

It may be an advantage of the present invention that the gap makes the optoelectronic device less susceptible, typically resistant, to shorting and/or shunting across the trough. The gap between the semiconductor and the another semiconductor is designed to mitigate a charge transfer path/route from the semiconductor on one face of the trough, through the another semiconductor and into the semiconductor on the opposite face of the trough. This typically makes the optoelectronic device less susceptible to shunting.

The semiconductor may be a layer of semiconductor material. The conductor on the first and/or second face of the trough may be a layer of conductor material. The layer of semiconductor material is typically on top of the layer of conductor material. The layer of conductor material is typically underneath the layer of semiconductor material. The conductor material is normally in contact with the first face and/or the second face of the trough and the semiconductor material.

The conductor on the first and/or second face of the trough is normally one or more of on, in contact with and coated on the first and/or second face of the trough. The semiconductor is normally one or more of on, in contact with and coated on the first and/or second face of the trough.

The first and/or second faces of the trough may each be coated with an adhesive. The adhesive may be a layer of adhesive material. The layer of adhesive material is typically in contact with one or more of the first face of the trough, second face of the trough, the conductor on the first and/or second face of the trough and the semiconductor.

The adhesive may also be a conductor, typically an electrical conductor. The conductor on the first and/or second face of the trough and the adhesive may be the same material and/or the same layer.

The trough may be any shape, may be symmetrical, may be an asymmetric v-shape. The first face of the trough may be longer than the second face of the trough or the second face of the trough may be longer than the first face of the trough.

When the first face of the trough is longer than the second face of the trough the first face is typically at least 1000nm long and the second face is typically at least 300nm long. When the second face of the trough is longer than the first face of the trough the second face is typically at least 1000nm long and the first face is typically at least 300nm long.

When the first face of the trough is longer than the second face of the trough or the second face of the trough is longer than the first face of the trough, the trough typically has an asymmetric shape.

The another semiconductor typically contacts only the first face of the trough and/or the semiconductor on the first face of the trough and the another semiconductor contacts only the second face of the trough and/or the conductor on the second face of the trough.

The semiconductor may coat and/or cover from 20 to 80%, normally from 40 to 60% and optionally about 50% of the first face of the trough. The semiconductor may coat and/or cover about 75% of the first face of the trough. The conductor on the first and/or second face of the trough may coat and/or cover from 20 to 80%, normally from 40 to 60% and optionally about 50% of the first and/or second face of the trough. The conductor on the first and/or second face of the trough may coat and/or cover about 75% of the first and/or second face of the trough.

It may be an advantage of the present invention that when the conductor on the first and/or second face of the trough and/or semiconductor coat cover about 50%, preferably about 75%, of the first and/or second face of the trough, one or more of the efficiency, electrical current generated, power output and photoelectric conversion efficiency of the optoelectronic device is increased.

The coat of the conductor on the first and/or second face of the trough and/or semiconductor may be from 20nm to 1000nm thick, normally from 25nm to 500nm thick and typically from 30nm to 200nm thick. The coat of the conductor on the first and/or second face of the trough and/or semiconductor may therefore be referred to as a relatively thin coating.

It may be an advantage of the present invention that when the another semiconductor thickness is about 200nm, one or more of the efficiency, electrical current generated, power output and photoelectric conversion efficiency of the optoelectronic device is increased. When the another semiconductor thickness is about 200nm, the width of the trough may be about 1µm, although this may vary for different trough shapes.

There is typically an aperture in the another semiconductor. The aperture may be referred to as a gap and/or crack. The shape of the aperture is typically substantially conformal with the shape of the trough. The shape of the aperture may match the shape of the trough. The material for storing electrical potential energy normally fills the aperture in the another semiconductor.

The material for storing electrical potential energy may be and/or may be referred to as a dielectric and/or insulator material. The insulator material is typically an electrical insulator material. It may be an advantage of the present invention that the insulator material makes the optoelectronic device less susceptible to shorting and/or shunting across the trough. The insulator material may increase the length of and/or mitigate a charge transfer path/route across the top of the trough and this typically makes the optoelectronic device less susceptible to shunting.

The material for storing electrical potential energy may comprise one or more of Barium titanate, Niobium pentoxide, conjugated polymers, modified polymers such as doped acrylates or the like. When referred to herein a doped acrylate is typically doped with nanoparticles and can be highly polarised.

The semiconductor is typically an n-type semiconductor. The another semiconductor is typically a p-type semiconductor. In an alternative embodiment the semiconductor is a p-type semiconductor and the another semiconductor is an n-type semiconductor.

The n-type and p-type semiconductors may comprise one or more of silicon, amorphous silicon, hydrogenated amorphous silicon, aluminium, germanium, gallium nitride, gallium arsenide, aluminium phosphide, aluminium arsenide, copper iodide, zinc oxide, lead sulphide, selenium, boron phosphide, boron arsenide, gallium, indium nitride, indium phosphide, cadmium selenide, cadmium sulphide, cadmium telluride, zinc sulphide, zinc selenide, zinc telluride, copper chloride, copper sulphide, copper oxide, tin sulphide, tin telluride, zinc phosphide, titanium oxide, tin oxide, lithium niobate, lead iodide, gallium selenide, tin sulphide, iron oxide, nickel oxide, copper indium selenide, copper zinc tin sulphide, iron disulphide, copper zinc antimony sulphide, tungsten oxide, niobium pentoxide, lead oxide.

The n-type semiconductor typically comprises one or more of silicon, germanium, phosphorus, selenium, tellurium, cadmium sulphide, zinc, indium, titanium, niobium, nickel, tin, oxides of the above and doped semiconducting oxides.

The p-type semiconductor typically comprises one or more of silicon, germanium, cadmium telluride, copper indium gallium selenide ('CIGS'), copper indium gallium diselenide, copper indium selenide (CIS), copper gallium selenide, copper oxide, nickel oxide, tungsten oxide, boron, beryllium, zinc, cadmium, copper zinc tin sulphide (CZTS), perovskite, calcium titanium oxide, calcium titanate and lead sulphide.

The another semiconductor may be an electron blocking material such as molybdenum trioxide. The electron blocking material may be a hole transporting, electron blocking material, such as vanadium pentoxide, tungsten oxide, tantalum pentoxide, spiro-polymers, and p-dot polymers. The semiconductor may be a heterojunction, that is a mixture of one or more of a p-type semiconductor, n-type semiconductor and donor acceptor material.

The semiconductor and another semiconductor may meet at an interface and/or boundary. The interface is typically referred to as a p-n junction. The interface is typically and/or may be referred to as a diode. The semiconductor and another semiconductor may together be referred to as an active material.

The conductor on the first and/or second face of the trough is typically ohmic and/or an ohmic contact to the another semiconductor. The semiconductor is typically rectifying and/or a rectifying contact to the another semiconductor.

The active material in the trough and/or in a cavity of the trough and on the first and second faces of the trough may provide ohmic and rectifying contacts for insertion or extraction of charge from the active material. The active material may be one or more of photovoltaic, light emitting and ion conducting.

The substrate of the optoelectronic device typically provides an interconnected electrical circuit comprising one or more of the conductor, the semiconductor and the another semiconductor. The interconnected electrical circuit typically comprises a complex series of interconnected p-n junctions and/or diodes.

It may be an advantage of the present invention that the interconnected electrical circuit produces a higher voltage or electrical energy per unit surface area compared to other known optoelectronic devices.

A surface of the substrate comprising the peaks and troughs may be referred to as a structured surface. The structured surface is typically not flat. The substrate may have another surface that is flat.

The substrate may comprise a curable resin and in particular a UV curable resin. The substrate may comprise one or more of an acrylic resin coated onto polyvinyl chloride (PVC), acrylic resin coated onto polyethylene terephthalate (PET), acrylic resin coated onto polyethylene naphthalate (PEN), a biopolymer coated onto polyvinyl chloride (PVC), a biopolymer coated onto polyethylene terephthalate (PET) and a biopolymer coated onto polyethylene naphthalate (PEN).

The substrate is typically flexible. In this way, the substrate is only limited in size and length by the size of flexible substrate (e.g. film) available. For example, a length of 36,000m is typically available. In addition such substrates are processable by continuous process, such as for example a so-called roll-to-roll manufacturing process rather than sheet to sheet or wafer batch processes as are typical in device manufacture.

The optoelectronic device is typically a solar photovoltaic cell.

It may be an advantage of the present invention that filing the troughs with the another semiconductor may be easier than filing other structures, including grooves of a grooved structure. The three-dimensional array of peaks and troughs may be and/or may be referred to as, a series of surface perturbations. It may be an advantage of the present invention that the series of surface perturbations of the three-dimensional array of peaks and troughs is easier to fill than a substrate comprising a series of grooves.

The three-dimensional array of peaks and troughs may be referred to as a convoluted shaped surface.

The peaks may be cones and/or cone shaped. The peaks are typically pyramids. The peaks may have a pointed or a rounded apex or vertex. The peaks may have a circular or triangular or square base or regular or irregular polygonal base. The peaks typically have a circular base with radius r. All the peaks may have the same radius r or the radius r may vary. The radius r may be from 6 microns to 300 nanometers, normally from 3 microns to 300 nanometers and typically from 1.5 microns to 500 nanometers. Thus, in each range of values for radius r the difference between the largest and the smallest radius in the range may be 5.7 microns, normally 2.7 microns and typically 1 micron. The radius r may be greater than or equal to 20 microns for the peaks of the energy storage device. When they have a square base, the length of one side of the base may be greater than or equal to 20 microns.

The substrate provides a substantially planar surface and the troughs typically extend a first distance from the substantially planar surface and the peaks typically extend a second distance from the substantially planar surface. The first and second distances are typically the same. The first and second distances are typically measured from a half way point between a bottom of the troughs and a top or apex of the peaks.

The second distance the peaks extend from the substantially planar surface may be referred to as the height of the peaks. The height of the peaks is typically related and/or dependent on the size of the base of the peaks. The height of the peaks is typically from 0.3 to 10µm, normally from 0.3 to 6µm. The width of the base of the peaks is typically from 0.3 to 10µm, normally from 0.3 to 6µm.

The distance between the apex or vertex of two peaks may be substantially the same, typically the same. The distance between the apex or vertex of two peaks is typically from 0.3 to 100µm, normally from 0.3 to 5µm. The distance between the apex or vertex of two peaks typically defines the trough.

The peaks may be square. That is the base of the peak is square and the top of what would be the apex or vertex of the peak is also square. The peaks may be polygonal shapes and/or polygonal in shape.

The another semiconductor may be a perovskite. The another semiconductor may comprise a perovskite. The semiconductor may comprise titanium oxide or other electron extraction layer. The inventors of the present invention appreciate that a perovskite in isolation is not typically referred to as a semiconductor, but in the context of the present invention, a perovskite can provide the optoelectronic device with the same function as the semiconductors described herein.

Statistical variation in the distance between the metal conductors on the first and second faces means that, in use, some short circuits may occur in the device if left untreated. After the conductors have been applied to the substrate, a short circuit detection and mitigation/removal process may be implemented. For example, the capacitance of the conductively coated substrate may first be measured. The measured capacitance may allow an assessment as to whether any short circuits are present therein. If mitigation or removal of any short circuits is then desired, a variable-frequency AC voltage may be passed through the conductors.

According to a second aspect of the present invention there is provided a method of conditioning a substrate according to claim 13.

The conductor on the first and second face of the trough is typically the same material. The conductor on the first and/or second face of the trough may be a metal. The conductor on the first and/or second face of the trough is typically in contact, normally electrical contact with the material for storing electrical potential energy in the trough. The conductor on the first and/or second face of the trough is typically an electrical conductor.

The step of supplying the AC voltage to the conductor on the first or second face of the trough typically supplies energy in the form of heat to the conductor on the first or second face of the trough to create the gap.

The method normally includes the step of dissipating the energy in the form of heat across the conductor on the first and/or second face of the trough.

The gap is typically created at the bottom of the trough. This is statistically where the cross-section of the conductor on the first and/or second face of the trough is the thinnest.

Short circuits typically occur when the conductor on the first face of the trough is in contact with the conductor on the second face of the trough.

The waveform of the AC voltage may be adjusted so that the magnitude of the current which passes through the short circuit is high enough to raise the temperature of the conductor. The energy in the form of heat is typically enough to overheat the short circuit. This typically causes the short circuit to fail. Consequently, short circuits are removed. Removal of the short circuits changes the overall impedance of the substrate, making it more difficult for a fixed AC frequency to overheat any remaining short circuits. Accordingly, the input frequency may be altered throughout the process in order to adjust to the capacitive reactance changes and changes to the overall impedance. Thus, substantially all the short circuits may be removed.

If the AC input frequency is too high, the method will use more power, and may mask the successful removal of short circuits, since the variation in impedance upon their removal will be very small. Therefore, it is preferable to use an AC input frequency that is neither too high nor too low for the short circuit mitigation/removal application. The highest and lowest frequencies needed may be predicted based on the trough dimensions and the number of short circuits detected.

Alternatively, a suitable pulsed power supply can be used as an input, wherein a pulsed waveform comprises all the component frequencies that are estimated to be required over the impedance range of the circuit of conductors. In this scenario, variable AC frequencies do not need to be supplied separately as they are all contained within the pulsed waveform.

Features and optional features of the second aspect of the present invention may be incorporated into the first aspect of the present invention and vice versa.

In both the first and second aspects of the invention, the energy storage device is typically made via a so-called roll to roll process. A roll of substrate is unwound and processed to add the resin coating in which the three-dimensional array of peaks and troughs is then formed. Thereafter the first and second faces of the troughs of the array are coated with conductor and/or semiconductor and the troughs filled, partially filled or overfilled with the material for storing electrical potential energy and, if present, the another semiconductor material. The finished device is then rolled ready for storage, transportation and use.

Embodiments of the invention will now be described by way of example only and with reference to the accompanying drawings, in which:
Figure 1 is a perspective views of the surface of the substrate of the energy storage device;
Figures 2a-d area cross-sectional view of troughs of the energy storage device;
Figures 3a and 3b are cross-sectional views of troughs of the energy storage device according to another embodiment; and
Figure 4 is a cross-sectional view of troughs of the energy storage and optoelectronic device.

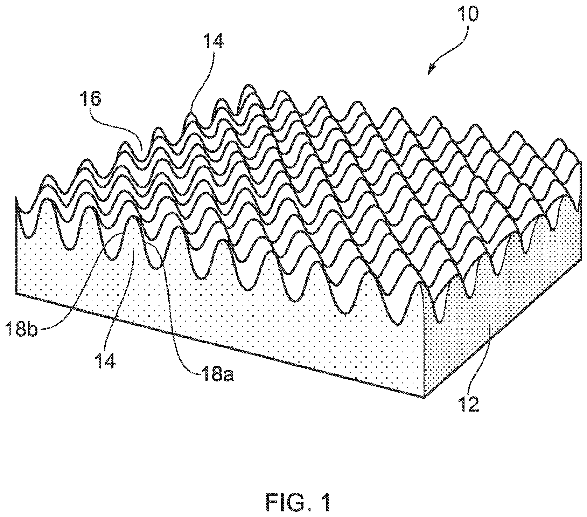

Figure 1 shows an energy storage device 10 comprising a substrate 12 having a three-dimensional array of peaks 14 and troughs 16. Each peak 14 has a first 18a and a second face 18b.

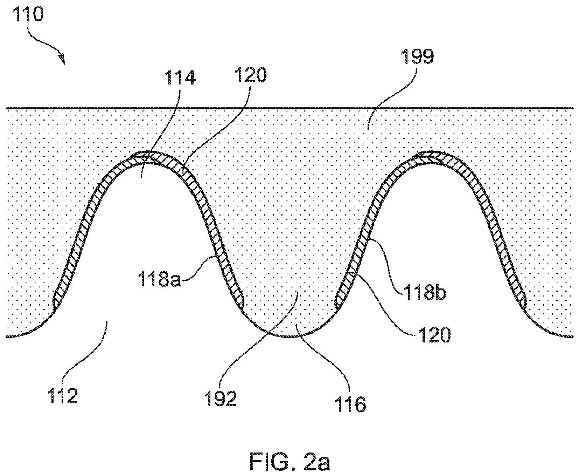

Figures 2a-d show an energy storage device 110 comprising a series of peaks 114 and troughs 116 and material for storing electrical potential energy 199. The walls of the troughs 116 have a coat of a conductor 120.

The energy storage device 110 comprises a substrate 112 having a three-dimensional array of peaks 114 and troughs 116. Each trough 116 has a first 118a and a second 118b face. The first 118a and second 118b faces of the troughs 116 have a conductor 120 thereon. The troughs 116 contain a material for storing electrical potential energy 199.

The conductor 120 on the first face 118a of the trough 116 is not in electrical contact with the conductor 120 on the second face 118b of the trough 114. There is a gap 192 at the bottom of the trough 116 between the coat of conductor 120 on the first face 118a of the trough 116 and the coat of conductor 120 on the second face 118b of the trough 116.

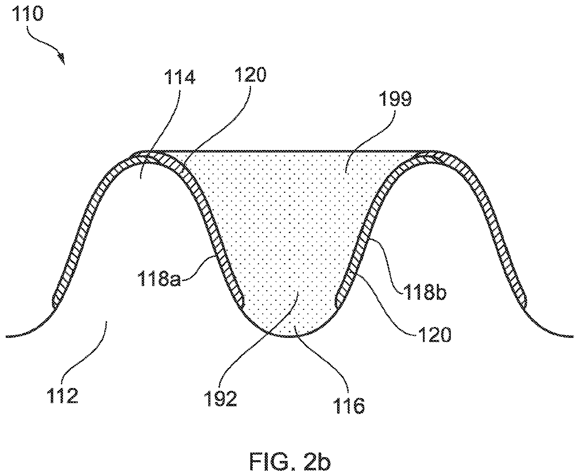

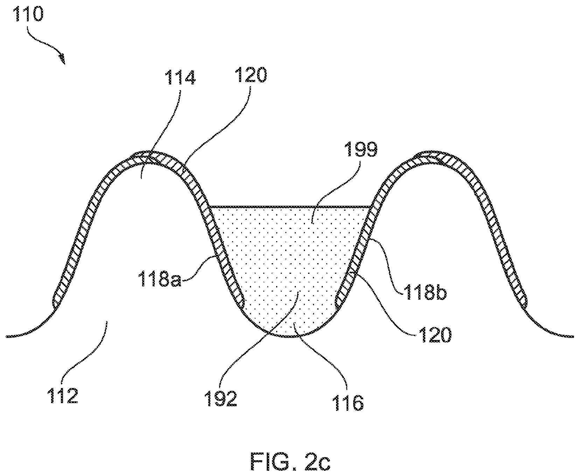

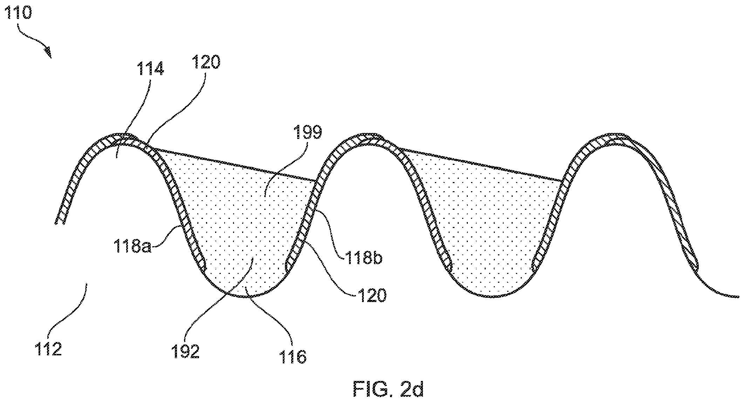

In Figure 2a the material for storing electrical potential energy 199 overfills the troughs 116, and is above the top of the peaks 114. In Figure 2b the material for storing electrical potential energy 199 fills the troughs 116, and is level with the top of the peaks 114. In Figure 2c the material for storing electrical potential energy 199 only partially fills the troughs 116. In Figure 2d the material for storing electrical potential energy 199 is tilted with respect to the plane of the substrate 112.

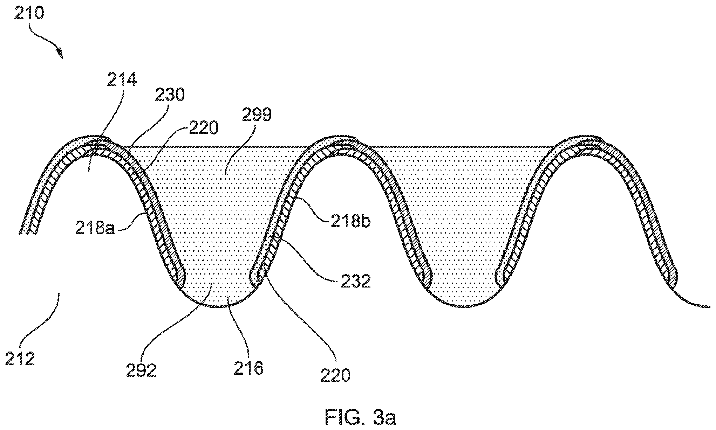

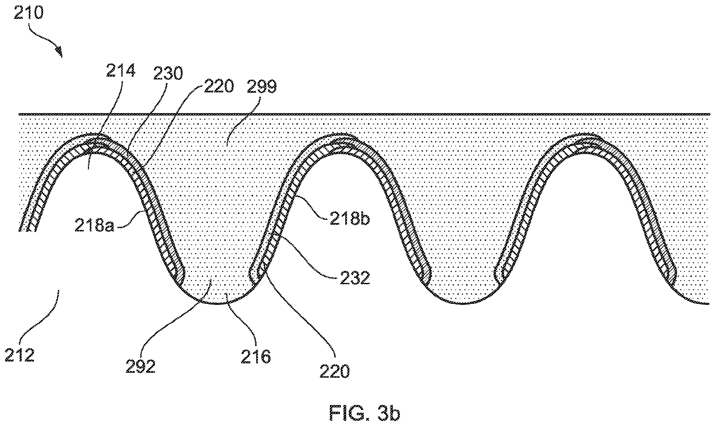

Figure 3a shows an energy storage device 210 comprising a series of peaks 214 and troughs 216 and material for storing electrical potential energy 299. The faces of the troughs 216 have a coat of a conductor 220. Features of Figures 3a and 3b that are also shown in Figures 2a-d have been given the same reference numbers with the prefix '2' instead of '1'.

Figure 3a also shows a layer or coat of carbon 230 on the first face 218a of the trough 216 and another layer or coat of carbon 232 on the second face 218b of the trough 216.

In Figure 3a the material for storing electrical potential energy 299 fills the troughs 216, and is level with the top of the peaks 214. In Figure 3b the material for storing electrical potential energy 299 overfills the troughs 216, and is above the top of the peaks 214.

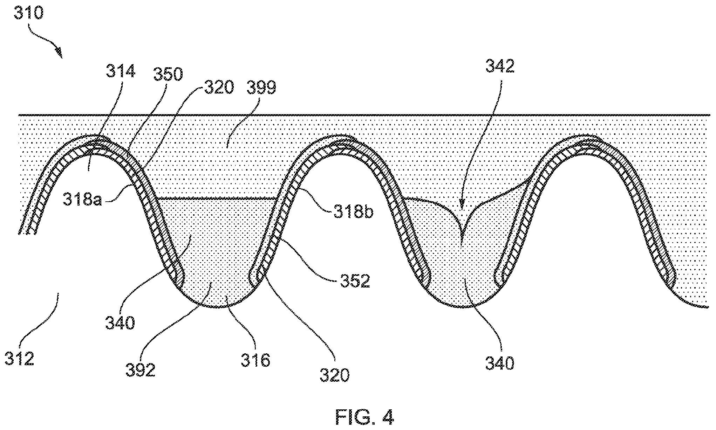

Figure 4 shows a combined energy storage and optoelectronic device 310 comprising a substrate 312 comprising a trough 316 having a first 318a and a second 318b face and material for storing electrical potential energy 399 in the trough 316.

Features of Figure 4 that are also shown in Figures 2a-d and Figures 3a and 3b have been given the same reference numbers with the prefix '3' instead of '1' or '2'.

The first face 318a of the trough 316 is coated with a conductor 320 and the second face 318b of the trough 316 is coated with a conductor 320. The first face 318a of the trough 316 is also coated with molybdenum oxide 350 and the second face 318b of the trough 316 is also coated with a semiconductor 352. The molybdenum oxide 350 and semiconductor 352 are in contact with another semiconductor 340 in the trough.

The first face 318a, second face 318b, molybdenum oxide 350 and semiconductor 352 are in contact with the another semiconductor 340.

The material for storing electrical potential energy 399 covers the another semiconductor 340 in the trough 316 and fills the remaining volume of the trough 316 not occupied by the semiconductor 352, molybdenum oxide 350 and the another semiconductor 340. In one trough 316 there is an aperture or crack 342 in the material for storing electrical potential energy 399.

The material for storing electrical potential energy 399 is a transparent material such as a doped acrylate. In this way, light is able to reach the active material formed by the semiconductor 352 and the another semiconductor 340.

The material for storing electrical potential energy 399 stores electrical energy generated by the optoelectronic device 310.

## Claims

1. An energy storage device (10) comprising:
a substrate (12) having a structured three-dimensional, surface **characterized in that** from the surface an array of peaks (14) and troughs (16) extends;
each trough (116) having a first and a second face (118a, 118b);
the first and second face (118a, 118b) of the troughs (16) having a conductor (120) thereon; and
the troughs (16) at least partially filled with a material (199) for storing electrical potential energy,
wherein the conductor on the first and second faces of the trough and the material for storing electrical potential energy are all in electrical communication such that electrical current can flow between neighbouring troughs, through neighbouring peaks.

2. An energy storage device (10) according to claim 1 wherein the material (199) for storing electrical potential energy stores the electrical potential energy in the form of one or more of chemical energy, electrostatic energy, pseudocapacitance and electrostatic double layer capacitance (EDLC).

3. An energy storage device (10) according to claim 1 or claim 2 wherein the material (199) for storing electrical potential energy comprises a battery.

4. An energy storage device (10) according to claim 3 wherein the material (199) for storing electrical potential energy stores the electrical potential energy in the form of chemical energy.

5. An energy storage device (10) according to claim 1 or claim 2 wherein the material (199) for storing electrical potential energy comprises a capacitor or supercapacitor.

6. An energy storage device (10) according to claim 5 wherein the material (199) for storing electrical potential energy stores the electrical potential energy in the form of one or more of electrostatic energy, pseudocapacitance and electrostatic double layer capacitance (EDLC).

7. An energy storage device (10) according to any preceding claim wherein the first face (118a) of the trough (116) is at a first angle relative to a normal from the substrate (12) and the second face (118b) of the trough (116) is at a second angle relative to the normal from the substrate(12), the first and second angles are from 45 to less than 90°.

8. An energy storage device (10) according to any preceding claim wherein the conductor (120) on the first and/or second face (118a, 118b) of the trough (116) is a metal or a conductive non-metal.

9. An energy storage device (10) according to any preceding claim wherein there is a gap (192) between the conductor (120) on the first face (118a) and the conductor (120) on the second face (118b) of the trough (116), such that the conductor (120) on the first face (118a) of the trough (116) is not in electrical contact with the conductor (120) on the second face (118b) of the trough (116).

10. An energy storage device (10) according to any preceding claim wherein the material (199) for storing electrical potential energy in the troughs is from 100 to 500nm deep.

11. An energy storage device (10) according to any preceding claim wherein the energy storage device (10) is also an optoelectronic device, the first face (118a) of each trough (116) having a coat of a semiconductor.

12. An energy storage device (10) according to claim 11 wherein the semiconductor on the first face (118a) and the conductor (120) on the second face (118a) of the trough (116) are in contact with another semiconductor (340) in the trough and the material (199) for storing electrical potential energy one or more of coats, is on top of, and covers the another semiconductor in the trough (116).

13. A method of conditioning a substrate (12) comprised by an energy storage device (10) of claim 1, the method comprising the steps of:
providing the substrate (12) **characterized by** the substrate /12) having a three-dimensional array of peaks (14) and troughs (16), each trough (116) having a first and a second face (118a, 118b), the first face (118a) of the trough (116) having a conductor (120) thereon, the second face (118b) of the trough (116) having a conductor (120) thereon and the trough (116) containing a material (199) for storing electrical potential energy;
supplying an AC voltage to the conductor (120) on the first or second face (118a, 118b) of the trough (116); and
creating a gap (192) between the conductor (120) on the first face (118a) and the conductor (120) on the second face (118b).

14. A method of conditioning a substrate (12) according to claim 13 wherein the step of supplying the AC voltage to the conductor (120) on the first or second face (118a, 118b) of the trough (116) supplies energy in the form of heat to the conductor on the first or second face (118a, 118b) of the trough (116) to create the gap (192).

15. A method of conditioning a substrate (12) according to claim 13 or claim 14 wherein the gap (192) is created at the bottom of the trough (116).

## Patentansprüche

1. Energiespeichervorrichtung (10), umfassend:
ein Substrat (12) mit einer strukturierten dreidimensionalen Oberfläche, **dadurch gekennzeichnet, dass** sich von der Oberfläche aus eine Anordnung von Spitzen (14) und Mulden (16) erstreckt; jede Mulde (116) eine erste und eine zweite Fläche (118a, 118b) aufweist;
die erste und zweite Fläche (118a, 118b) der Mulden (16) einen Leiter (120) darauf aufweisen; und
die Mulden (16) zumindest teilweise mit einem Material (199) zum Speichern elektrischer potentieller Energie gefüllt sind,
wobei der Leiter auf der ersten und zweiten Fläche der Mulde und das Material zum Speichern elektrischer potentieller Energie alle so in elektrischer Verbindung stehen, dass elektrischer Strom zwischen benachbarten Mulden, durch benachbarte Spitzen fließen kann.

2. Energiespeichervorrichtung (10) nach Anspruch 1, wobei das Material (199) zum Speichern elektrischer potentieller Energie die elektrische potentielle Energie in Form von einer oder mehreren von chemischer Energie, elektrostatischer Energie, Pseudokapazität und elektrostatischer Doppelschichtkapazität (EDLC) speichert.

3. Energiespeichervorrichtung (10) nach Anspruch 1 oder Anspruch 2, wobei das Material (199) zum Speichern elektrischer potentieller Energie eine Batterie umfasst.

4. Energiespeichervorrichtung (10) nach Anspruch 3, wobei das Material (199) zum Speichern elektrischer potentieller Energie die elektrische potentielle Energie in Form von chemischer Energie speichert.

5. Energiespeichervorrichtung (10) nach Anspruch 1 oder Anspruch 2, wobei das Material (199) zum Speichern elektrischer potentieller Energie einen Kondensator oder Superkondensator umfasst.

6. Energiespeichervorrichtung (10) nach Anspruch 5, wobei das Material (199) zum Speichern elektrischer potentieller Energie die elektrische potentielle Energie in Form von einer oder mehreren von elektrostatischer Energie, Pseudokapazität und elektrostatischer Doppelschichtkapazität (EDLC) speichert.

7. Energiespeichervorrichtung (10) nach einem der vorhergehenden Ansprüche, wobei die die erste Fläche (118a) der Mulde (116) in einem ersten Winkel relativ zu einer Normalen des Substrats (12) steht und die zweite Fläche (118b) der Mulde (116) in einem zweiten Winkel relativ zur Normalen des Substrats (12) steht, wobei der erste und der zweite Winkel zwischen 45 und weniger als 90° liegen.

8. Energiespeichervorrichtung (10) nach einem der vorhergehenden Ansprüche, wobei der Leiter (120) auf der ersten und/oder zweiten Fläche (118a, 118b) der Mulde (116) ein Metall oder ein leitendes Nichtmetall ist.

9. Energiespeichervorrichtung (10) nach einem der vorhergehenden Ansprüche, wobei zwischen dem Leiter (120) auf der ersten Fläche (118a) und dem Leiter (120) auf der zweiten Fläche (118b) der Mulde (116) ein Spalt (192) besteht, so dass der Leiter (120) auf der ersten Fläche (118a) der Mulde (116) nicht in elektrischem Kontakt mit dem Leiter (120) auf der zweiten Fläche (118b) der Mulde (116) steht.

10. Energiespeichervorrichtung (10) nach einem der vorhergehenden Ansprüche, wobei das Material (199) zum Speichern elektrischer potentieller Energie in den Mulden 100 bis 500 nm tief ist.

11. Energiespeichervorrichtung (10) nach einem der vorhergehenden Ansprüche, wobei die Energiespeichervorrichtung (10) auch eine optoelektronische Vorrichtung ist, wobei die erste Fläche (118a) jeder Mulde (116) einen Überzug aus einem Halbleiter aufweist.

12. Energiespeichervorrichtung (10) nach Anspruch 11, wobei der Halbleiter auf der ersten Fläche (118a) und der Leiter (120) auf der zweiten Fläche (118a) der Mulde (116) mit einem anderen Halbleiter (340) in der Mulde in Kontakt stehen und sich das Material (199) zum Speichern elektrischer potentieller Energie, ein oder mehrere der Überzüge, auf der Oberseite des anderen Halbleiters in der Mulde (116) befindet und diesen bedeckt.

13. Verfahren zum Konditionieren eines Substrats (12), das in einer Energiespeichervorrichtung (10) nach Anspruch 1 umfasst ist, wobei das Verfahren die Schritte umfasst:
Bereitstellen des Substrats (12), das **dadurch gekennzeichnet ist, dass** das Substrat (12) eine dreidimensionale Anordnung von Spitzen (14) und
Mulden (16) aufweist, wobei jede Mulde (116) eine erste und eine zweite Fläche (118a, 118b) aufweist, wobei die erste Fläche (118a) der Mulde (116) einen Leiter (120) darauf aufweist, die zweite Fläche (118b) der Mulde (116) einen Leiter (120) darauf aufweist und die Mulde (116) ein Material (199) zum Speichern elektrischer potentieller Energie enthält;
Anlegen einer Wechselspannung an den Leiter (120) auf der ersten oder zweiten Fläche (118a, 118b) der Mulde (116); und
Erzeugen eines Spalts (192) zwischen dem Leiter (120) auf der ersten Fläche (118a) und dem Leiter (120) auf der zweiten Fläche (118b).

14. Verfahren zum Konditionieren eines Substrats (12) nach Anspruch 13, wobei der Schritt des Anlegens der Wechselspannung an den Leiter (120) auf der ersten oder zweiten Fläche (118a, 118b) der Mulde (116) Energie in Form von Wärme an den Leiter auf der ersten oder zweiten Fläche (118a, 118b) der Mulde (116) anlegt, um den Spalt (192) zu erzeugen.

15. Verfahren zum Konditionieren eines Substrats (12) nach Anspruch 13 oder Anspruch 14, wobei der Spalt (192) am Boden der Mulde (116) erzeugt wird.

## Revendications

1. Dispositif de stockage d'énergie (10) comprenant :
un substrat (12) possédant une surface tridimensionnelle structurée, **caractérisé en ce qu'**à partir de la surface un réseau de pics (14) et de creux (16) s'étend ;
chaque creux (116) comportant une première et une seconde face (118a, 118b) ;
les première et seconde faces (118a, 118b) des creux (16) comportant un conducteur (120) sur celles-ci ; et
les creux (16) étant remplis au moins partiellement d'un matériau (199) destiné au stockage d'énergie potentielle électrique,
ledit conducteur sur les première et seconde faces du creux et ledit matériau destiné au stockage d'énergie potentielle électrique étant tous en communication électrique de sorte que le courant électrique puisse circuler entre les creux voisins, à travers les pics voisins.

2. Dispositif de stockage d'énergie (10) selon la revendication 1, ledit matériau (199) destiné au stockage d'énergie potentielle électrique stockant l'énergie potentielle électrique sous la forme de l'une ou de plusieurs de l'énergie chimique, de l'énergie électrostatique, de la pseudocapacité et de la capacité électrostatique à double couche (EDLC).

3. Dispositif de stockage d'énergie (10) selon la revendication 1 ou la revendication 2, ledit matériau (199) destiné au stockage d'énergie potentielle électrique comprenant une batterie.

4. Dispositif de stockage d'énergie (10) selon la revendication 3, ledit matériau (199) destiné au stockage d'énergie potentielle électrique stockant l'énergie potentielle électrique sous la forme d'énergie chimique.

5. Dispositif de stockage d'énergie (10) selon la revendication 1 ou la revendication 2, ledit matériau (199) destiné au stockage d'énergie potentielle électrique comprenant un condensateur ou un supercondensateur.

6. Dispositif de stockage d'énergie (10) selon la revendication 5, ledit matériau (199) destiné au stockage d'énergie potentielle électrique stockant l'énergie potentielle électrique sous la forme d'une ou plusieurs de l'énergie électrostatique, de la pseudocapacité et de la capacité électrostatique à double couche (EDLC).

7. Dispositif de stockage d'énergie (10) selon une quelconque revendication précédente, ladite
première face (118a) du creux (116) étant selon un premier angle par rapport à la normale du substrat (12) et ladite seconde face (118b) du creux (116) étant selon un second angle par rapport à la normale du substrat (12), lesdits premier et second angles allant de 45 à moins de 90°.

8. Dispositif de stockage d'énergie (10) selon une quelconque revendication précédente, ledit conducteur (120) sur la première et/ou la seconde face (118a, 118b) du creux (116) étant un métal ou un non-métal conducteur.

9. Dispositif de stockage d'énergie (10) selon une quelconque revendication précédente, un espace (192) existant entre le conducteur (120) sur la première face (118a) et le conducteur (120) sur la seconde face (118b) du creux (116), de sorte que le conducteur (120) sur la première face (118a) du creux (116) ne soit pas en contact électrique avec le conducteur (120) sur la seconde face (118b) du creux (116).

10. Dispositif de stockage d'énergie (10) selon une quelconque revendication précédente, ledit matériau (199) destiné au stockage d'énergie potentielle électrique dans les creux possédant une profondeur de 100 à 500 nm.

11. Dispositif de stockage d'énergie (10) selon une quelconque revendication précédente, ledit dispositif de stockage d'énergie (10) étant également un dispositif optoélectronique, la première face (118a) de chaque creux (116) possédant un revêtement d'un semi-conducteur.

12. Dispositif de stockage d'énergie (10) selon la revendication 11, ledit semi-conducteur sur la première face (118a) et ledit conducteur (120) sur la seconde face (118a) du creux (116) étant en contact avec un autre semi-conducteur (340) dans le creux et ledit matériau (199) destiné au stockage d'énergie potentielle électrique, un ou plusieurs des revêtements, se trouvant au-dessus de l'autre semi-conducteur dans le creux (116) et recouvrant celui-ci.

13. Procédé de conditionnement d'un substrat (12) comprenant un dispositif de stockage d'énergie (10) selon la revendication 1, le procédé comprenant les étapes de :
fourniture du substrat (12) **caractérisé par** le substrat (12) comportant un réseau tridimensionnel de pics (14) et
de creux (16), chaque creux (116) comportant une première et une seconde face (118a, 118b), la première face (118a) du creux (116) comportant un conducteur (120) sur celle-ci, la seconde face (118b) du creux (116) comportant un conducteur (120) sur celle-ci et le creux (116) contenant un matériau (199) destiné au stockage d'énergie potentielle électrique ;
la fourniture d'une tension CA au conducteur (120) sur la première ou la seconde face (118a, 118b) du creux (116) ; et
la création d'un espace (192) entre le conducteur (120) sur la première face (118a) et le conducteur (120) sur la seconde face (118b).

14. Procédé de conditionnement d'un substrat (12) selon la revendication 13, ladite étape de fourniture de la tension CA au conducteur (120) sur la première ou la seconde face (118a, 118b) du creux (116) fournissant de l'énergie sous la forme de chaleur au conducteur sur la première ou la seconde face (118a, 118b) du creux (116) pour créer l'espace (192).

15. Procédé de conditionnement d'un substrat (12) selon la revendication 13 ou la revendication 14, ledit espace (192) étant créé au fond du creux (116).
